Europäisches Patentamt

European Patent Office

Office européen des brevets

(19)

(11) **EP 1 193 879 A1**

## (12) DEMANDE DE BREVET EUROPEEN

(43) Date de publication:
**03.04.2002 Bulletin 2002/14**

(51) Int Cl.7: **H03L 7/197**

(21) Numéro de dépôt: **01203623.2**

(22) Date de dépôt: **25.09.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **29.09.2000 FR 0012459**
**26.12.2000 FR 0017041**

(71) Demandeur: **Koninklijke Philips Electronics N.V.**
**5621 BA Eindhoven (NL)**

(72) Inventeur: **Jovenin, Fabrice,**
**Société Civile S.P.I.D.**
**75008 Paris (FR)**

(74) Mandataire: **Chaffraix, Jean**
**Société Civile S.P.I.D.**
**156, Boulevard Haussmann**
**75008 Paris (FR)**

(54) **Synthétiseur de fréquences à faible bruit et à réponse rapide, et procédé de synthèse de fréquences correspondant**

(57)  L'invention concerne un synthétiseur de fréquences comportant, dans une boucle à verrouillage de phase :

- un comparateur phase-fréquence (16),
- au moins un oscillateur commandé en tension (12) associé à des moyens de sélection (50, 80, 82) d'une bande de fréquences d'oscillation, et
- un diviseur de fréquences (14) connecté entre l'oscillateur et le comparateur,

et comprenant en outre une source de tension propre (90) connectée aux moyens de sélection pour fournir aux moyens de sélection une tension de commande propre.
  Application aux téléphones portables.

FIG. 3

EP 1 193 879 A1

**Description**

Domaine technique

La présente invention concerne un synthétiseur de fréquences à diviseur fractionnaire et un procédé de synthèse de fréquences correspondant.

Elle concerne plus précisément un synthétiseur de fréquences à faible bruit autorisant un ajustage précis de la fréquence et capable de commuter rapidement entre plusieurs fréquences sélectionnées les unes après les autres.

Un tel synthétiseur de fréquences peut être utilisé dans différents types de circuits radioélectriques et en particulier dans des étages de réception et/ou d'émission de ces circuits. A titre d'exemple, le synthétiseur de fréquences de l'invention peut être utilisé dans des équipements de téléphonie sans fil, tels que les téléphones portables.

Etat de la technique antérieure

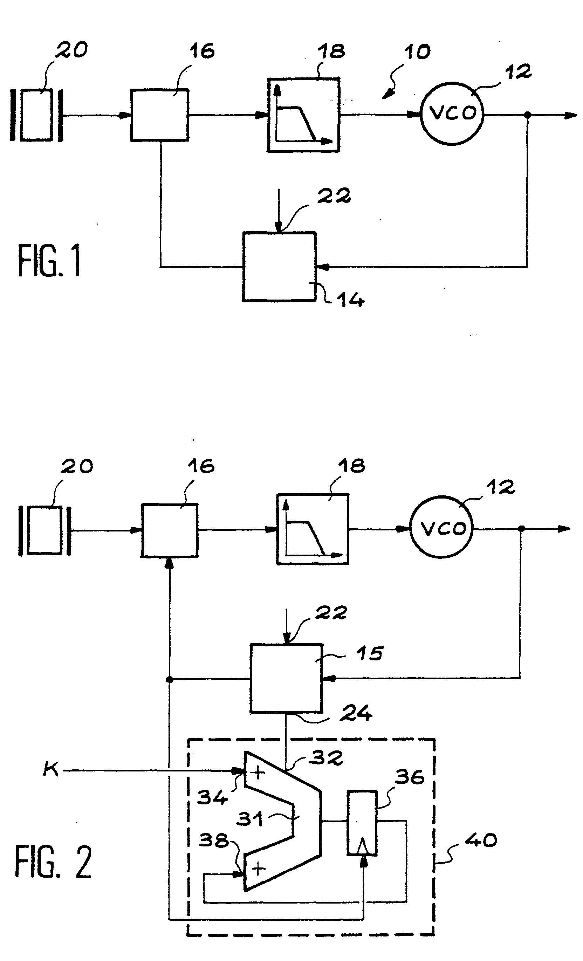

Les figures 1 et 2 annexées illustrent respectivement un synthétiseur de fréquences ajustable par valeurs entières, et un synthétiseur de fréquences ajustable par valeurs fractionnaires. On entend par synthétiseur de fréquences ajustable par valeurs fractionnaires, un synthétiseur de fréquences dont la fréquence peut être ajustée par multiples entiers ou non entiers d'une fréquence de référence. De tels dispositifs sont en soi connus et illustrés, par exemple, par les documents (1), (2) et (3) dont les références complètes sont précisées à la fin de la description.

La figure 1 indique la structure de base d'un synthétiseur de fréquences qui est construit autour d'une boucle à verrouillage de phase 10. La boucle à verrouillage de phase comporte pour l'essentiel un oscillateur commandé en tension 12, un diviseur de fréquences 14, un comparateur phase-fréquence 16 et un filtre de boucle 18.

L'oscillateur commandé en tension 12, encore désigné par « oscillateur VCO » dans la suite du texte, délivre un signal de sortie dont la fréquence peut être augmentée ou diminuée en fonction d'une tension de commande appliquée à son entrée. Cette tension de commande est fournie par le comparateur phase-fréquence 16 qui est relié à l'entrée de l'oscillateur VCO 12 par l'intermédiaire du filtre de boucle 18.

Le comparateur phase-fréquence 16 compare la fréquence (ou la phase) d'un signal délivré par le diviseur de fréquences 14 et la fréquence d'un signal de référence délivré, dans l'exemple de la figure, par un dispositif à quartz 20. Lorsque la fréquence du signal délivré par le diviseur de fréquences est inférieure à celle du signal de référence, le comparateur phase-fréquence, associé au filtre de boucle 18, fournit une tension commandant l'augmentation de la fréquence de l'oscillateur VCO 12. A l'inverse, la fréquence de l'oscillateur VCO est diminuée lorsque la fréquence du signal délivré par le diviseur de fréquences est supérieure à celle du signal de référence.

Le diviseur de fréquences 14 est un dispositif construit autour d'un certain nombre de bascules et ne peut donc diviser la fréquence du signal de l'oscillateur VCO 12 que par des valeurs entières. La rapport de division, ajustable par valeurs entières, est un nombre entier noté N. Une entrée d'ajustage indiquée par une flèche 22 permet de fixer la valeur N.

La fréquence de l'oscillateur VCO, notée $F_{VCO}$ est donc telle que :

$$(1) \qquad F_{VCO} = N * F_{ref}$$

où $F_{ref}$ est la fréquence du signal de référence délivré par le dispositif à quartz 20.

On observe qu'une modification d'une unité de la valeur du rapport de division N (entier), provoque une variation égale à $F_{ref}$, de la fréquence de l'oscillateur VCO. Ainsi, il n'est pas possible d'ajuster la fréquence de l'oscillateur VCO 12 avec une résolution supérieure à $F_{ref}$. Or, dans la mesure où la fréquence du signal de référence est élevée, cette résolution peut s'avérer très insuffisante.

Un ajustage beaucoup plus fin de la fréquence du signal de sortie de la boucle 10, c'est-à-dire de la fréquence du signal délivré par l'oscillateur VCO 12, peut être obtenu avec un synthétiseur de fréquences conforme à la figure 2.

Le synthétiseur de fréquences de la figure 2 comprend une boucle à verrouillage de phase 10 avec les mêmes éléments que ceux de la boucle 10 de la figure 1.

Le diviseur de fréquences 14, en revanche, présente non seulement une entrée d'ajustage 22 pour fixer la valeur N du rapport de division, mais également une entrée de commutation 24 pour commuter le rapport de division entre deux ou plusieurs valeurs consécutives autour de la valeur N. Dans l'exemple de la figure 2, l'entrée de commutation 24 du diviseur de fréquences 14 permet de commuter le rapport de division entre deux valeurs qui sont N et N+1.

L'entrée de commutation 24 est reliée à un modulateur sigma-delta 30 et plus précisément à une borne 32 de retenue de dépassement (overflow) de ce modulateur.

Le modulateur sigma-delta 30, qui, dans l'exemple de la figure est un modulateur numérique d'ordre 1 avec un additionneur de mots 31, présente une première entrée numérique 34 pour une consigne d'ajustage notée K. La consigne d'ajustage est additionnée à une valeur numérique délivrée par un registre à décalage 36 du modulateur. Le registre 36 est cadencé par le signal de sortie du diviseur de fréquences 14, et reçoit la sortie de l'additionneur de mots 31. Il est relié à une deuxième entrée numérique 38 de l'additionneur. Lorsque la somme de la consigne d'ajustage et de la sortie du registre 36 est inférieure à la capacité numérique de l'additionneur 31, la retenue de dépassement prend la valeur logique 0, par exemple. En revanche, lorsque la somme est supérieure à la capacité de l'additionneur 31, la retenue prend la valeur logique complémentaire, 1 en l'occurrence.

Le diviseur de fréquences 14 est conçu de façon à effectuer une division de fréquences avec un premier rapport de division lorsque son entrée de commutation 24 reçoit le premier état logique et de façon à effectuer une division avec un deuxième rapport de division, différent de +/-1, lorsque l'entrée 24 reçoit le deuxième état de commutation.

Dans l'exemple décrit le rapport de division est N pour un état logique 0 et est N+1 pour un état logique 1.

Bien qu'à tout instant le rapport de division du diviseur de fréquences soit un nombre ender, la commutation répétée du rapport entre N et N+1, permet d'obtenir un rapport de division moyen résultant compris entre ces deux valeurs, c'est-à-dire un rapport non entier.

De façon plus précise, on a :

$$Fvco = \frac{1}{T_N + T_{N+1}} [T_N * N * F_{ref} + T_{N+1} * (N + 1) * F_{ref}]$$

Soit

$$Fvco = \left[ N + \frac{T_{N+1}}{T_N + T_{N+1}} \right] * F_{ref}$$

Dans ces expressions $T_N$ et $T_{N+1}$ sont respectivement les périodes pendant lesquelles le rapport de division est égal à N et N+1.

En considérant que la consigne d'ajustage K appliquée à la première entrée 34 du modulateur sigma-delta est codée sur L bits, et que la capacité maximum de l'additionneur est de $2^L$-1, on peut définir une partie fractionnaire du rapport de division égale à $\frac{K}{2^L}$. La composante fractionnaire $\frac{K}{2^L}$ est encore notée k dans la suite du texte.

On a :

$$(2) \quad Fvco = \left[ N + \frac{K}{2^L} \right] * F_{ref}$$

Pour des valeurs faibles de la consigne d'ajustage (K≅0) la fréquence de sortie est voisine de $F_{ref}*(N)$ et pour des valeurs fortes de la consigne d'ajustage (K≅$2^L$), la fréquence de sortie est voisine de $F_{ref}*(N+1)$.

Il est ainsi possible d'ajuster continûment la fréquence de la boucle à verrouillage de phase entre deux valeurs fixées par le choix du rapport de division N appliquée à l'entrée d'ajustage 22 du diviseur de fréquences 14 et par le choix de la consigne d'ajustage K appliquée au modulateur sigma-delta.

Dans les boucles à verrouillage de phase classiques, conformes à la figure 1, la fréquence d'oscillation de l'oscillateur commandé en tension peut être ajustée par des « pas » de fréquence dont la valeur est $F_{ref}$. Le « pas » correspond alors à une variation du rapport de division de N à N+1 ou de N à N-1. Ceci apparaît clairement en se reportant à la formule (1) indiquée précédemment.

Afin d'obtenir toutefois un ajustage relativement précis de la fréquence de la boucle, la valeur de la fréquence $F_{ref}$ du signal de référence est choisie de préférence faible. A simple titre d'exemple, la fréquence $F_{ref}$, et donc le pas d'ajustage, peuvent être de l'ordre de 200kHz.

On peut noter également qu'une faible fréquence de référence conduit à retenir des valeurs N du rapport de division élevées. En effet, on rappelle que la fréquence de l'oscillateur commandé en tension est le produit de la fréquence de référence (relativement faible) par le rapport de division N (relativement élevé).

La contrainte du choix d'une valeur relativement faible pour la fréquence de référence n'existe toutefois pas dans une boucle à verrouillage de phase conforme à la figure 2.

La formule (2) donnée précédemment montre en effet qu'il est possible d'ajuster la fréquence en faisant varier la valeur de la partie fractionnaire k, c'est-à-dire $K/2^L$. Le pas d'ajustage peut donc être aussi fin que $F_{ref}/2^L$. Pour un codage sur 8 ou 16 bits, c'est-à-dire pour L=8 ou L=16, par exemple, l'ajustage peut être presque continu, et ce, de façon quasi indépendante de la fréquence de référence.

Ainsi pour des boucles à verrouillage de phase à diviseur fractionnaire, la fréquence de référence est préférentiellement choisie très élevée. Elle est par exemple de l'ordre de 26MHz. Une fréquence élevée permet en effet de corriger plus finement les dérives de la boucle et autorise ainsi une plus grande stabilité.

On peut encore noter que le choix d'une fréquence de référence relativement élevée permet de retenir des valeurs faibles de N, c'est-à-dire des valeurs faibles de la partie entière du rapport de division.

La pulsation propre de la boucle à verrouillage de phase, notée $\omega_n$ peut être exprimée en fonction du gain $K_{VCO}$ de l'oscillateur 12 commandé en tension, du gain $K_\phi$ d'une pompe de charge du comparateur phase fréquence 16, de la capacité C d'un condensateur du filtre de boucle 18 et de la partie entière N du rapport de division du diviseur 22. La relation est la suivante :

$$(3) \qquad \omega_n = \sqrt{\frac{K_{VCO} \cdot K_\phi}{N \cdot C}}$$

De la valeur $\omega_n$ de la pulsation de la boucle dépend aussi le temps de commutation $t_s$ de la boucle à verrouillage de phase. Le temps de commutation $t_s$ peut être compris comme le temps nécessaire à la boucle pour s'établir à un régime d'oscillation de pulsation donnée ou le temps nécessaire pour commuter d'une valeur de pulsation ou de fréquence à une autre.

Le temps de commutation $t_s$ est relié à la pulsation par la relation suivante :

$$t_s = (2{,}5 \text{x} 2\text{x}\pi)/\omega_n$$

En se reportant encore à la formule (3) de la pulsation $\omega_n$ indiquée ci-dessus, on constate qu'à pulsation égale, des valeurs relativement faibles du rapport de division N, ou tout au moins de sa partie entière, doivent être compensées par des valeurs relativement fortes de la capacité C du filtre de boucle. En effet, les valeurs $K_{VCO}$ et $K_\phi$ sont des constantes liées à l'oscillateur et à la pompe de charge du comparateur phase-fréquence.

Le choix d'une capacité forte pour le filtre de boucle fait apparaître l'influence d'un autre paramètre temporel t qui est le temps de charge de cette capacité. Le filtre de boucle peut être considéré comme un filtre passe bande avec un condensateur capable de convertir un courant i, non filtré en fréquence, de la pompe de charge du convertisseur phase-fréquence en une tension $V_{tune}$, filtrée en fréquence, et utilisée pour commander l'oscillateur VCO. Le temps t de charge de la capacité C, est lié au courant i et à la tension $V_{tune}$ par la relation suivante :

$$(4) \qquad t = C \text{x} V_{tune}/i$$

Dans cette expression C est la capacité du filtre de boucle.

Le temps de charge t de la capacité vient s'ajouter au temps de commutation ts évoqué précédemment et est susceptible de pénaliser la vitesse d'accord de la boucle à une fréquence souhaitée. Ce problème est spécifique aux boucles comprenant un diviseur fractionnaire c'est-à-dire aux boucles pilotées par une fréquence de référence élevée et présentant un rapport de division N faible.

L'état de la technique est encore illustré par des documents dont les références sont précisées à la fin de la description.

Exposé de l'invention

L'invention a pour but de proposer un synthétiseur de fréquences et un procédé de synthèse de fréquences correspondant, ne présentant pas les limitations évoquées ci-dessus.

Un but est en particulier de proposer un synthétiseur de fréquences du type à diviseur fractionnaire, capable de fonctionner avec une fréquence de référence élevée, et présentant un temps de commutation global très court.

Un autre but de l'invention est de proposer un tel synthétiseur dans lequel il n'est pas nécessaire de recourir à une multiplication du nombre de pompes de charges ou au surdimensionnement de la pompe de charge équipant le convertisseur phase fréquence d'une boucle à verrouillage de phase.

Un but de l'invention est encore de proposer un tel synthétiseur qui soit affranchi, dans une large mesure, de la dispersion de caractéristiques des composants et de l'influence de dérives thermiques.

Enfin, un but de l'invention est de fournir un synthétiseur de fréquence à faible bruit présentant un bruit de phase particulièrement réduit.

Pour atteindre les buts mentionnés ci-dessus l'invention propose d'équiper la boucle à verrouillage de phase d'un oscillateur commandé en tension associé à des moyens de sélection de bandes de fréquences d'oscillation. En disposant de plusieurs bandes de fréquences d'oscillation, encore appelées « bandes passantes », celles-ci peuvent être moins larges que la bande de fréquence globale susceptible d'être générée par le synthétiseur de fréquences. Or en conservant la tension de commande $V_{tune}$ inchangée pour des bandes de fréquences plus étroites il est possible de réduire le gain $K_{VCO}$ de l'oscillateur commandé en tension dans ces bandes de fréquences. Le gain $K_{VCO}$ d'un oscillateur commandé en tension est en effet compris comme le rapport de la variation de la fréquence rapportée à celle de la tension de commande.

En se reportant à l'expression (3) de la pulsation de la boucle à verrouillage de phase donnée dans la partie introductive du texte, on constate qu'une diminution du gain $K_{VCO}$ autorise, à valeur de pulsation égale, une diminution de la valeur de la capacité C du filtre de boucle. Or, une capacité C plus faible permet de réduire le temps t de charge. On peut se reporter à ce sujet à l'équation (4) également donnée dans la partie introductive.

En se référant toujours à cette même formule, on aurait pu observer qu'une augmentation du courant i aurait abouti également à une réduction du temps de charge t. En revanche cette autre solution, non retenue par l'invention, aurait nécessité une nouvelle conception de la pompe de charge du comparateur phase-fréquence pour augmenter l'intensité du courant i qu'elle délivre.

La sélection des bandes de fréquences d'oscillation a recours à une tension de commande de façon que la sélection puisse avoir lieu automatiquement. La tension de commande peut être utilisée pour sélectionner une capacité ou un étage d'un oscillateur. Cet aspect est décrit dans la suite du texte. L'invention propose notamment d'équiper le synthétiseur de fréquences d'une source de tension propre, c'est-à-dire une source ne présentant pas de bruit, et d'appliquer cette tension aux moyens de sélection comme tension de commande.

Ainsi, l'invention concerne plus précisément un synthétiseur de fréquences comportant, dans une boucle à verrouillage de phase :

- un comparateur phase-fréquence,
- au moins un oscillateur commandé en tension associé à des moyens de sélection d'une bande de fréquences d'oscillation, et
- un diviseur de fréquences connecté entre l'oscillateur et le comparateur,

et comprenant en outre une source de tension propre connectée aux moyens de sélection pour fournir aux moyens de sélection une tension de commande propre.

L'utilisation d'une tension propre revêt ici un intérêt particulier car elle permet d'affranchir le synthétiseur de bruits de phase. L'influence de bruits de phase serait en effet néfaste dans nombre d'applications liées à la transmission de signaux par voie hertzienne.

Les moyens de sélection d'un bande passante peuvent être réalisés de différentes façons. A titre d'exemple, ces moyens peuvent comporter des commutateurs permettant de sélectionner différents étages d'un oscillateur commandé en tension dont chaque étage constitue un oscillateur VCO autonome avec sa propre bande passante et sa propre fréquence centrale. Selon une autre possibilité, les moyens de sélection peuvent comporter une batterie de capacités qui peuvent être commutées pour être associées à un unique VCO afin d'en modifier la fréquence centrale et la bande passante.

Les capacités peuvent être formées par des condensateurs ou par des varactors. Elles forment, dans ce cas, avec l'oscillateur VCO unique, des étages d'oscillateur assimilables à une pluralité d'oscillateurs indépendants. Les varactors (voltage-variable-capacitors) sont des condensateurs dont la valeur de capacité est ajustable par l'intermédiaire d'une tension de commande. La capacité des varactors évolue continûment en fonction d'une tension qui leur est appliquée et qui peut varier, par exemple entre 0 et 4 Volt. Il est également possible d'utiliser les varactors en commutation entre deux valeurs de tension, et en l'occurrence en commutation du type tout ou rien. Dans ce cas, on leur applique soit une première tension de commande non nulle (par exemple 4 volts) soit une deuxième tension de préférence nulle (0 volt). Le varactor s'apparente alors à un interrupteur en série avec un condensateur de valeur fixe. Les varactors peuvent comporter plusieurs étages autonomes fonctionnant chacun comme un condensateur dont la capacité est ajustable par une tension de commande. Dans ce dernier cas le synthétiseur peut comporter un multiplexeur pour distribuer la tension de commande aux étages de varactor.

Une difficulté de la commande est liée à la fourniture d'une tension de commande propre. La tension d'alimentation est en effet susceptible d'être affectée d'un bruit qui nuit à la stabilité de sélection des étages d'oscillateur. Cette difficulté peut être surmontée conformément à l'invention en équipant le synthétiseur d'une capacité servant de source de tension et de moyens de charge transitoire de la capacité.

On entend par moyens de charge transitoire de la capacité des moyens de charge qui ne sont actifs que lors d'une période transitoire, de préférence très courte, et initiée de préférence à la mise en fonctionnement du synthétiseur de fréquences.

Comme les moyens de sélection ne nécessitent qu'une tension de commande et non d'une tension d'alimentation, sensiblement aucun courant n'est prélevé sur la capacité. Ainsi, au terme de la période transitoire, la capacité peut n'être plus soumise à aucune charge de maintien. Elle est donc autonome et affranchie du bruit de l'alimentation du synthétiseur et constitue une source de tension propre.

Dans des applications particulières de l'invention la tension d'alimentation générale du synthétiseur de fréquences peut être inférieure à la tension de commande requise par les moyens de sélection d'une bande de fréquences d'oscillation. A titre d'exemple la tension d'alimentation générale (régulée) peut être de l'ordre de 2 Volt (1,8V) tandis que la tension de commande requise pour des varactors est de l'ordre de 4 Volt (3,5 V). Dans un tel cas, l'invention propose d'équiper les moyens de charge transitoire d'un doubleur de tension non régénéré. Le doubleur de tension non régénéré présente également un fonctionnement transitoire lors duquel il effectue un décalage du potentiel de référence d'un condensateur. La commutation de décalage, fortement génératrice de bruit, n'a lieu qu'une seule fois et pendant une durée très courte, après chaque mise en fonctionnement du synthétiseur de fréquences.

L'invention concerne également un procédé de synthèse de fréquences au moyen d'un synthétiseur tel que décrit. Le procédé comprend alors une phase transitoire d'établissement de la tension propre, suivie d'au moins une phase de synthèse de fréquences.

D'autres caractéristiques et avantages de l'invention ressortiront de la description qui va suivre, en référence aux figures des dessins annexés. Cette description est donnée à titre purement illustratif et non limitatif.

Brève description des figures.

La figure 1, déjà décrite, est un schéma de principe simplifié d'un synthétiseur de fréquences connu, à ajustage de fréquence discret.

La figure 2, déjà décrite, est un schéma de principe simplifié d'un synthétiseur de fréquences connu, à ajustage de fréquence continu.

La figure 3, est un schéma simplifié d'un synthétiseur de fréquences conforme à l'invention.

La figure 4 est une représentation schématique d'une source de tension propre utilisée dans le dispositif de la figure 3.

La figure 5 est une représentation schématique simplifiée d'un convertisseur de fréquences utilisant un synthétiseur de fréquences conforme à l'invention.

Description détaillée de modes de mise en oeuvre de l'invention.

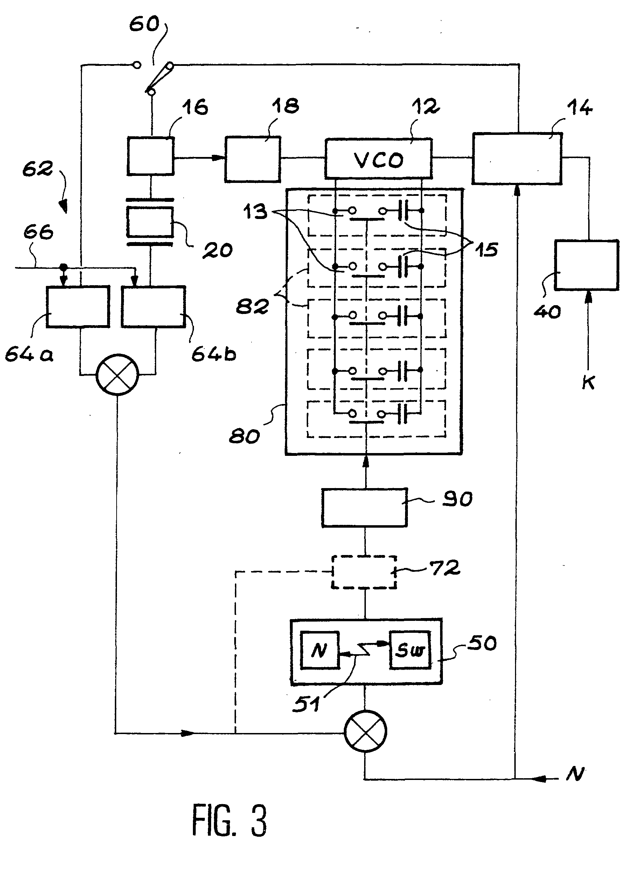

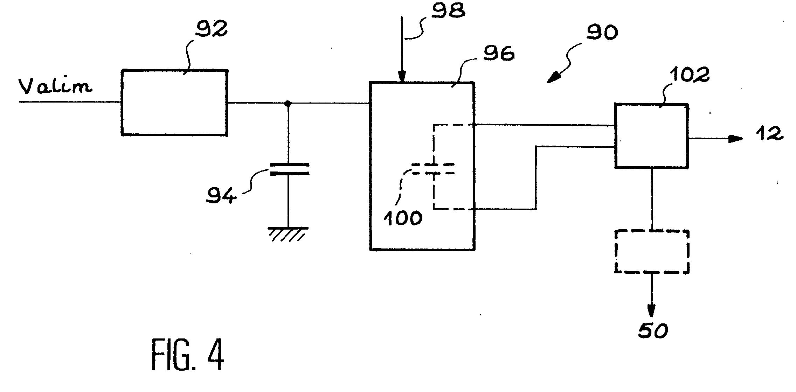

Dans la description qui suit des parties des figures 3 et 4 qui sont identiques, similaires ou équivalentes à des parties déjà décrites en référence aux figures 1 et 2, sont repérées par les mêmes références numériques. On peut ainsi se reporter, à leur sujet, à la description qui précède.

L'oscillateur unique des figures 1 et 2 est remplacé dans la figure 3 par un oscillateur 12 associé à un varactor 80. Le varactor 80 comprend plusieurs étages 82, encore appelés « lignes », qui présentent chacun une capacité ajustable par une tension de commande.

Les différentes lignes de varactor 82 sont connectées en parallèle à un oscillateur commandé en tension 12. Il convient de distinguer ici la tension de commande de l'oscillateur fournie par un comparateur phase-fréquence 16 associé au filtre de boucle 18 et une tension de commande des lignes de varactor fournie par une source de tension 90 décrite ultérieurement.

Les lignes de varactor 82 sont utilisées pour appliquer à l'oscillateur VCO 12 différentes capacités. Ceci permet d'accorder l'oscillateur sur différentes fréquences centrales d'oscillation et de sélectionner différentes bandes de fréquences d'oscillation. Les bandes de fréquences d'oscillation, sont les gammes de fréquences du signal fournies par l'oscillateur commandé en tension lorsque la tension de commande varie d'une tension minimum, de l'ordre de 0 Volt, à une tension maximum de l'ordre de 4 Volt. La fréquence centrale est définie comme la fréquence du signal de l'oscillateur lorsqu'une tension de commande moyenne lui est appliquée.

Il serait a priori envisageable de sélectionner les bandes de fréquences d'oscillation simplement en faisant varier la tension de commande de la capacité d'une unique ligne de varactor. Il est toutefois très difficile de concevoir une source de tension variable ne présentant pas de bruit.

En raison de cette difficulté, on préfère retenir un varactor 80 avec une pluralité de lignes indépendantes dans lequel chaque ligne est commandée entre deux valeurs de capacité dans un mode du type tout ou rien. Comme le montre la figure 1, chaque ligne de varactor 82 est symboliquement représentée par un condensateur 15, connecté en série avec un interrupteur 13 destiné à connecter ou non le condensateur à l'oscillateur VCO.

La commande des interrupteurs implique d'une part une table logique 50 et d'autre part la source de tension de commande 90 décrite ci-après.

Comme indiqué dans la partie introductive, les deux paramètres de commande essentiels du synthétiseur de fréquences sont la partie entière N du rapport de division, et la partie fractionnaire qui est commandée par une consigne d'ajustage K appliquée au modulateur sigma-delta 40.

La valeur N est appliquée directement au diviseur de fréquences 14, mais aussi à une table logique 50. Un pointeur 51 de la table logique permet de sélectionner, en fonction de la valeur N, une consigne numérique de commande des lignes de varactor 82.

Le tableau I ci-après donne un exemple de correspondance entre les valeurs N, une consigne logique de commande des lignes de varactors et des gammes de fréquences du signal de réponse de l'oscillateur commandé en fréquence pour des valeurs minimales et maximales de la tension $V_{tune}$. Les fréquences sont exprimées en mégahertz. Chaque bit des consignes de commande correspond par exemple à l'activation d'une ligne de varactor. On peut observer à ce sujet que le tableau I ne correspond pas exactement à la figure 3 qui, pour des raisons de clarté, ne représente que cinq lignes de varactor tandis que le tableau distingue sept consignes différentes.

TABLEAU I

| N | $\leq 8$ | 9 à 14 | 11 à 17 | 14 à 20 | 18 à 23 | 21 à 27 | $\geq 28$ |
|---|---|---|---|---|---|---|---|
| consigne | "0000,00" | "0000,01" | "0001,01" | "0011,01" | "0111,01" | "1111,01" | "1111,11" |
| freq@0.4V | 1,757 | 1,787 | 1,817 | 1,858 | 1,893 | 1,939 | |
| Freq@3.8V | | 1,842 | 1,876 | 1,921 | 1,960 | 2,012 | 2,069 |

Par ailleurs, le tableau I ne coïncide pas exactement avec le contenu de la table logique 50. En effet, certaines valeurs de N peuvent correspondre à plusieurs combinaisons de condensateurs des lignes de varactor. Ceci correspond à des recouvrements des gammes de fréquences susceptibles d'être générés par la sélection de différentes bandes de fréquence pour l'oscillateur.

Lorsque deux combinaisons de condensateurs des lignes de varactor peuvent correspondre à une même valeur N, la table de correspondance peut être programmée, par exemple pour retenir la combinaison précédemment sélectionnée ou la combinaison correspondant à une fréquence centrale la plus proche de la fréquence d'oscillation souhaitée.

La table de correspondance peut comporter une mémoire ROM (mémoire à lecture seule), programmée par construction, ou éventuellement une mémoire programmable de type EPROM.

En fonctionnement normal de la synthèse de fréquences, la sortie du diviseur de fréquences est reliée à l'entrée du comparateur phase-fréquence 16. Toutefois, un commutateur 60 permet lors de la mise sous tension ou même lors de chaque modification de la valeur N de la partie entière du rapport de division, d'envoyer le signal divisé en fréquence vers un étage de calibrage 62.

L'étage de calibrage comporte deux compteurs sensiblement identiques 64a et 64b. Le premier compteur 64a est relié, par l'intermédiaire de l'interrupteur 60 à la sortie du diviseur de fréquences 14. Le deuxième compteur 64b, en revanche est directement relié au quartz de la source de fréquence de référence 20. Une commande de synchronisation 66 permet de déclencher simultanément le début et la fin du comptage des deux compteurs 64a et 64b.

En principe lorsque les étages d'oscillation sont parfaitement calibrés et qu'ils oscillent à la fréquence sélectionnée par le choix de N, aucune différence ne devrait exister entre le résultat de comptage des deux compteurs.. En effet si $F_{VCO}$, la fréquence d'oscillation de l'étage d'oscillateur sélectionné est telle que $F_{vco} = F_{ref}*N$, on devrait obtenir à la sortie du diviseur, c'est-à-dire à l'entrée du premier compteur, une fréquence de $F_{VCO}/N$ soit $F_{ref}$ qui est la fréquence de la source de fréquences de référence. On considère ici que, pendant une phase de calibrage, une composante fractionnaire k est maintenue nulle.

En revanche, si une différence de comptage existe entre les deux compteurs, une correction peut être effectuée. Une différence Mb-Ma est établie par un soustracteur 68, connecté aux sorties des deux compteurs 64a et 64b. Ma et Mb indiquent ici les valeurs de comptage des deux compteurs obtenus au terme d'un temps de comptage $\Delta t$ séparant les commandes de synchronisation de début et de fin de comptage.

Dans l'exemple décrit, l'erreur minimum entre la somme obtenue par les deux compteurs est de 1, ce qui correspond à une erreur en fréquence de une fois la valeur de la fréquence de référence $F_{ref}$. En d'autres termes on a :

$$F_{VCO} = (N + \Delta N)*F_{ref}$$

où $\Delta N$ est l'erreur de fréquence de l'oscillateur rapportée à une variation du rapport de division. On peut aussi écrire :

---

$$\text{Min } |Mb-Ma| = \Delta t * Fref/N*Min(\Delta N)$$

Dans cette expression Min désigne le minimum.

La valeur de Min($\Delta N$), qui n'est pas nécessairement entière, peut être choisie de préférence en fonction de l'importance du recouvrement entre les gammes de fréquences et donc les gammes de rapports de division associées aux différents étages d'oscillateur. Du choix de $\Delta N$ dépend aussi celui de $\Delta t$.

Dans l'exemple décrit ici, on choisit $\Delta N=1$ et donc $\Delta t=F_{ref}/N$ (avec Min|Mb-Ma|=1).

Le temps $\Delta t$ est faible devant les temps t et $t_s$ indiqués précédemment. A simple titre d'exemple, on peut avoir $\Delta t=20\mu sec$ pour $t_s=100\mu sec$ et $t=1000\mu sec$.

Le soustracteur 68 est relié à un additionneur 70, prévu à l'entrée de la table logique 50 pour ajouter à la valeur N la différence Mb-Ma. Ceci permet de prendre en compte l'erreur de comptage pour la sélection de l'étage de l'oscillateur. Il convient de noter que la valeur N appliquée au diviseur 14 est maintenue inchangée.

Selon une autre possibilité, représentée en trait discontinu la correction liée à la différence de comptage peut aussi, à titre d'alternative, être prise en compte à la sortie de la table 50. Dans ce cas toutefois la différence de comptage doit être traduite en une modification des consignes logiques (Sw) de commande des interrupteurs. Cette opération est réalisée par un registre 72.

A la fin de la phase de calibrage, une nouvelle commutation de l'interrupteur 60 permet de refermer la boucle jusqu'à la sélection d'une nouvelle valeur de N ou jusqu'à la sélection d'une valeur de N susceptible de modifier le choix de l'étage d'oscillateur VCO.

La figure 4 montre de façon plus précise la réalisation de la source de tension de commande 90. Celle-ci est connectée entre la table logique 50, ou le registre 72, et le varactor 80. La source de tension de commande comporte un régulateur à faible bruit 92 qui relie un condensateur 94, dit condensateur externe, à une borne de tension d'alimentation $V_{alim}$. Le régulateur délivre, par exemple, une tension régulée et continue de 1,8 Volt en étant alimenté sous une tension d'alimentation $V_{alim}$ de 2,7 Volt.

Le condensateur externe 94 est relié à un doubleur de tension 96 non régénéré. Celui-ci présente une commande de synchronisation 98 et comporte un condensateur interne 100.

Le condensateur interne est chargé dans un intervalle de temps compris entre une première et une deuxième impulsions de synchronisation qui suivent la mise sous tension du synthétiseur de fréquences. Ces impulsions, délivrées sur la commande de synchronisation 98, suivent la mise sous tension, par exemple à des intervalles de temps de 2,5 et de 5 $\mu sec$. Dans ces laps de temps, le condensateur interne est chargé à partir du condensateur externe jusqu'à atteindre également la même tension de charge, 1,8 volt, par exemple.

Le condensateur interne 100 est chargé entre un potentiel fourni par le condensateur externe et un potentiel de référence qui est, par exemple, le potentiel de masse. Lors de la deuxième impulsion de synchronisation la charge est interrompue et le potentiel de référence du condensateur interne est porté au potentiel du condensateur externe. En considérant que la capacité du condensateur externe est suffisamment supérieure à celle du condensateur interne pour pouvoir en négliger sa décharge, le décalage du potentiel de référence revient à doubler la tension disponible.

La commutation correspondant au doublement de tension est fortement génératrice de bruit mais n'est opérée qu'une seule fois lors de la mise sous tension. Ensuite le condensateur interne constitue une source de tension propre et indépendante de la tension d'alimentation. Les durées de charge et de commutation de doublement de tension sont très courtes, par exemple de l'ordre de 10$\mu sec$, par comparaison au temps nécessaire à l'oscillateur 12 pour s'établir à une fréquence d'oscillation souhaitée (environ 100$\mu sec$.) Le bruit initialement généré lors de la commutation ne perturbe donc pas le fonctionnement ultérieur du synthétiseur.

Les varactors connus présentent un courant de commande extrêmement faible, de l'ordre de quelques pico ampères, de sorte que la décharge du condensateur interne 100 est négligeable.

La tension « propre » fournie par le doubleur de tension est appliquée aux lignes de varactors par l'intermédiaire d'un multiplexeur 102. Le rôle du multiplexeur est essentiellement de réaliser une distribution de la tension de commande en fonction des codes logiques fournis par la table logique 50 visible sur la figure 3.

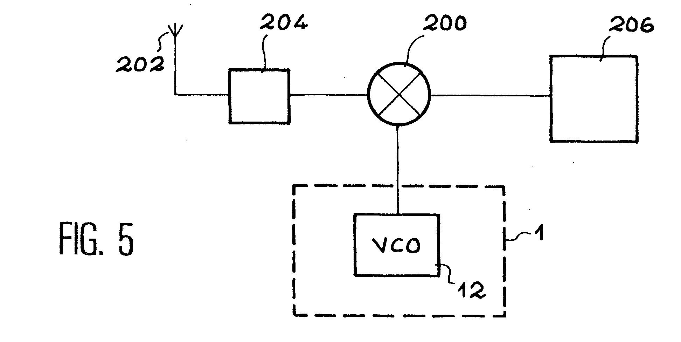

La figure 5 montre une application d'un synthétiseur de fréquences conforme à l'invention à la réalisation d'un convertisseur de fréquences et plus précisément à un convertisseur de fréquences dans un émetteur-récepteur de signaux.

Le convertisseur comprend un mélangeur auquel est connecté, d'une part, une source de signal à convertir, par exemple une antenne 202 associée à un filtre 204, et, d'autre part, une unité de traitement 206. L'unité de traitement 206 reçoit le signal dont la fréquence est convertie. Il s'agit, par exemple, d'une unité de traitement d'un téléphone portable.

Le mélangeur 200 reçoit également un signal de fréquence de référence d'une deuxième source de signal qui, dans l'exemple décrit, provient d'un oscillateur VCO 12 d'un synthétiseur de fréquences 1 conforme à l'invention.

**Documents cités :**

(1) EP-B-0 661 816
(2) EP-A-0 563 400
(3) "Fractional-N PII using delta-sigma modulation" de Thomas Stichelbout, Aalborg University, August 5, 1997, pages 1 à 21.
(4) WO 89/06456
(5) EP-A-0 910 170
(6) EP-A-0 664 616
7) EP-A-0 944 171
(8) US-5 053 723
(9) US-5 648 744

**Revendications**

1. Synthétiseur de fréquences comportant, dans une boucle à verrouillage de phase :

   - un comparateur phase-fréquence (16),
   - au moins un oscillateur commandé en tension (12) associé à des moyens de sélection (50, 80, 82) d'une bande de fréquences d'oscillation, et
   - un diviseur de fréquences (14) connecté entre l'oscillateur et le comparateur,

   et comprenant en outre une source de tension propre (90) connectée aux moyens de sélection pour fournir aux moyens de sélection une tension de commande propre.

2. Synthétiseur de fréquences selon la revendication 1, dans lequel les moyens de sélection comportent au moins un varactor (80) (voltage variable capacitor).

3. Synthétiseur de fréquences selon la revendication 2, dans lequel les moyens de sélection comprennent un varactor (80) à étages multiples (82) et dans lequel la source de tension propre (90) comporte un multiplexeur (102) pour distribuer la tension de commande propre aux étages (82) du varactor.

4. Synthétiseur de fréquences selon la revendication 1, dans lequel la source de tension propre (90) comporte une première capacité électrique (100) et des moyens (92, 94, 96) de charge transitoire de la capacité.

5. Synthétiseur de fréquences selon la revendication 4, dans lequel les moyens de charge comportent un régulateur de tension (92) associé à une deuxième capacité (94).

6. Synthétiseur selon la revendication 5, dans lequel les moyens de charge comportent un doubleur de tension non régénéré (96).

7. Synthétiseur de fréquences selon la revendication 2, dans lequel le diviseur de tension est un diviseur fractionnaire présentant un rapport de division avec une partie entière (N) et une partie fractionnaire (k) ajustables, et dans lequel les moyens de sélection d'un étage du varactor comportent une table logique (50) reliant des valeurs de la partie entière du rapport de division N à un choix d'étages (82) du varactor.

8. Procédé de synthèse de fréquences au moyen d'un synthétiseur de fréquences conforme à la revendication 1, comprenant une phase transitoire d'établissement de la tension propre, suivie d'au moins une phase de synthèse de fréquences.

9. Procédé selon la revendication 8, dans lequel la phase transitoire est initiée lors d'une première mise sous tension du synthétiseur de fréquences, et exécutée une seule fois jusqu'à une prochaine mise sous tension.

10. Convertisseur de fréquences comprenant un mélangeur (200) avec une première entrée connectée à une première source de signal (202, 204) délivrant un signal avec une fréquence à convertir, et comprenant une deuxième source de signal (1) avec une fréquence de référence, la deuxième source étant reliée à une deuxième entrée du mélangeur, **caractérisé en ce que** la deuxième source de signal (1) avec une fréquence de référence comprend un synthétiseur de fréquences (12) conforme à la revendication 1.

11. Utilisation d'un convertisseur de fréquences selon la revendication 10 dans un téléphone portable.

FIG. 1

FIG. 2

FIG. 3

FIG. 4

EP 1 193 879 A1

FIG. 5

EP 1 193 879 A1

**Office européen des brevets**

## RAPPORT DE RECHERCHE EUROPEENNE

Numéro de la demande

EP 01 20 3623

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 880 579 A (BAXTER DANIEL J ET AL) 9 mars 1999 (1999-03-09) * abrégé; figure 1 * | 1,5 | H03L7/197 |
| A | US 5 923 196 A (OKAMOTO SEIJI) 13 juillet 1999 (1999-07-13) * abrégé; figure 9 * | 1 | |
| A | EP 0 720 299 A (AT & T CORP) 3 juillet 1996 (1996-07-03) * figure 2 * | 2,3 | |
| A | EP 0 686 903 A (NOKIA MOBILE PHONES LTD) 13 décembre 1995 (1995-12-13) * abrégé; figure 2 * | 3,5,11 | |
| A | US 5 834 987 A (DENT PAUL WILKINSON) 10 novembre 1998 (1998-11-10) * abrégé; figure 3 * | 7 | |

DOMAINES TECHNIQUES RECHERCHES (Int.Cl.7)

H03L

Le présent rapport a été établi pour toutes les revendications

| Lieu de la recherche | Date d'achèvement de la recherche | Examinateur |
|---|---|---|
| LA HAYE | 19 décembre 2001 | Peeters, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 01 20 3623

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-12-2001

| Document brevet cité au rapport de recherche | | Date de publication | Membre(s) de la famille de brevet(s) | | Date de publication |
|---|---|---|---|---|---|
| US 5880579 | A | 09-03-1999 | AUCUN | | |
| US 5923196 | A | 13-07-1999 | JP | 10051304 A | 20-02-1998 |
| EP 0720299 | A | 03-07-1996 | US | 5528199 A | 18-06-1996 |
| | | | EP | 0720299 A1 | 03-07-1996 |
| | | | JP | 8242166 A | 17-09-1996 |
| | | | SG | 34350 A1 | 06-12-1996 |
| EP 0686903 | A | 13-12-1995 | FI | 942753 A | 11-12-1995 |
| | | | DE | 69522501 D1 | 11-10-2001 |
| | | | EP | 0686903 A2 | 13-12-1995 |
| | | | US | 5717319 A | 10-02-1998 |
| US 5834987 | A | 10-11-1998 | AU | 8668098 A | 22-02-1999 |
| | | | EP | 1000462 A1 | 17-05-2000 |
| | | | WO | 9907066 A1 | 11-02-1999 |

EPO FORM P0460

Pour tout renseignement concernant cette annexe : voir Journal Officiel de l'Office européen des brevets, No.12/82